# EUROPÄISCHE PATENTSCHRIFT

(11) **EP 0 313 914 B1**
(45) Veröffentlichungstag und Bekanntmachung des Hinweises auf die Patenterteilung: **03.03.1993**
(21) Anmeldenummer: 88116874.4
(22) Anmeldetag: 11.10.1988
(51) Int. Cl.: H03G 3/20, H03G 1/00

(54) **Schaltungsanordnung mit einem an einen opto-elektrischen Wandler angeschlossenen Vorverstärker**
Circuit comprising an input amplifier connected to an opto-electrical transducer
Circuit comportant un préamplificateur connecté à un transducteur opto-électrique

(30) Priorität: 26.10.1987 DE 3736181
(43) Veröffentlichungstag der Anmeldung: 03.05.1989
(73) Patentinhaber: SIEMENS AKTIENGESELLSCHAFT, 80333 München (DE)
(72) Erfinder: Bartenstein, Peter, Dipl.-Ing. (FH), D-8000 München 70 (DE); Prasse, Karl-Heinz, Dipl.-Ing., D-8102 Mittenwald (DE)

(56) Entgegenhaltungen:
- EP-A- 0 054 571
- DE-A- 2 641 525
- DE-A- 3 504 224
- US-A- 4 053 847

## Beschreibung

Die Erfindung bezieht sich auf eine, wie im Oberbegriff des Patentanspruches 1 angegebene Schaltungsanordnung mit einem an einen opto-elektrischen Wandler angeschlossenen Vorverstärker.

Eine derartige Schaltungsanordnung ist bereits aus der DE-PS 32 04 839 bekannt.

Die bekannte Schaltungsanordnung hat am Eingang eine Photodiode und enthält eine Kettenschaltung aus einer Emitterstufe und einer Kollektorstufe. Zwischen dem Ausgang der Kollektorstufe und dem Eingang der Emitterstufe ist in einem Gegenkopplungszweig ein Widerstand angeordnet. Diese aus zwei Stufen bestehende Schaltungsanordnung bildet einen sogenannten Transimpedanzverstärker, der einen vergleichsweise kleinen Eingangswiderstand und einen vergleichsweise sehr niedrigen Ausgangswiderstand hat. Parallel zum Kollektorwiderstand der Emitterstufe liegt die Drain-Source-Strecke eines Feldeffekttransistors, dessen Widerstand mit Hilfe einer Steuerspannung kontinuierlich steuerbar ist. Auf diese Weise läßt sich der effektive Kollektorwiderstand in weiten Grenzen ändern. Damit ergibt sich eine Möglichkeit einer externen Einstellung des Verstärkungsgrades der ersten Verstärkerstufe innerhalb eines relativ großen Dynamikbereichs.

Die bekannte Schaltungsanordnung soll außerdem die üblichen Anforderungen hinsichtlich rauschoptimaler Auskopplung der vom Photoempfänger abgegebenen elektrischen Signale, hoher Verstärkung und geringer Stromaufnahme zusammen mit einem möglichst kleinen Eigenrauschen aufweisen.

Weitere Schaltungsanordnungen mit einem an einen opto-elektrischen Wandler angeschlossenen Verstärker sind aus EP-A-0 054 571 und DE-A-3 504 224 bekannt.

Aufgabe der Erfindung ist es, eine Schaltungsanordnung der eingangs genannten Art derart auszubilden, daß sich ein besonders großer Dynamikbereich der Verstärkung ergibt und daß die Veränderung des Frequenzganges der Schaltungsanordnung dabei möglichst gering bleibt. Insbesondere soll auch bei Lichtpegelsprüngen, die zur Übersteuerung des Vorverstärkers führen, ein einwandfreier Betrieb gewährleistet sein.

Gemäß der Erfindung wird die Schaltungsanordnung zur Lösung der gestellten Aufgabe in der im kennzeichnenden Teil des Patentanspruches 1 angegebenen Weise ausgebildet. Dabei wird die Verstärkung des Vorverstärkers automatisch umgeschaltet, wobei unnötige Schaltvorgänge vermieden werden. Diese Umschaltung ergibt in Verbindung mit der Steuerung der regelbaren Verstärkeranordnung durch den Regler den Vorteil, daß der volle Dynamikbereich der Schaltungsanordnung durch eine doppelte Ausnutzung des Regelbereichs der regelbaren Verstärkeranordnung erzielt wird. Dabei werden mit Hilfe des in der Schaltungsanordnung enthaltenen Reglers sowohl langsame Pegeländerungen als auch Pegelsprünge ausgeregelt. Der vergrößerte Dynamikbereich läßt sich in vorteilhafter Weise leicht so bemessen, daß auch ein Kurzschlußbetrieb mit einem Lasersender möglich ist.

Der Vorverstärker, dessen Gegenkopplungszweig mit Hilfe des als Stellglied dienenden Feldeffekttransistors umschaltbar ist, kann in der in Anspruch 2 angegebenen Weise ausgebildet sein. Diese Ausbildung als Transimpedanzverstärker ist als solche bereits aus der DE-PS 32 04 839 bekannt. In Verbindung mit den im Patentanspruch 1 angegebenen Maßnahmen ergibt sich der besondere Vorteil, daß der als Stellglied dienende Feldeffekttransistor als Schalter betrieben wird und somit für die Umschaltung besonders sichere Schaltzustände gewährleistet.

Eine besonders vorteilhafte Ausbildung hinsichtlich des Transimpedanzverstärkers ergibt sich aus Anspruch 3. Als weiterer Transistor dient vorzugsweise ein Feldeffekttransistor. Die kleine Eingangskapazität des Feldeffekttransistors gestattet in vorteilhafter Weise eine besonders hochohmige Ausbildung des Gegenkopplungszweiges. Außerdem ermöglicht der Feldeffekttransistor ein geringes Rauschen bei großer Verstärkung.

Die Maßnahmen nach Anspruch 4 haben den Vorteil, daß sich der Gleichstromarbeitspunkt mit Hilfe eines Spannungsteilers unabhängig von den Wechselspannungseigenschaften des Verstärkers einstellen läßt und daß dabei das Differenzierglied aus einer niederohmigen Spannungsquelle gespeist wird.

Bei der Weiterbildung nach Anspruch 5 hebt der Hochpaß zweckmäßigerweise den tiefpaßförmigen Frequenzgang des Vorverstärkers auf. Mit Hilfe des der regelbaren Verstärkeranordnung nachgeschalteten Tiefpasses wird der gewünschte Frequenzgang der Schaltungsanordnung bestimmt.

Die weitere Ausgestaltung der Erfindung nach Anspruch 6 gestattet es in vorteilhafter Weise, für die beiden Potentiale, an die die Steuerstrecke des das Stellglied bildenden Feldeffekttransistors angeschlossen ist, besonders große Toleranzen zuzulassen.

Die Weiterbildung der Erfindung nach Anspruch 7 gestattet es in vorteilhafter Weise, Eigenschwingungen des Vorverstärkers sicher zu unterbinden und dabei sicherzustellen, daß der Frequenzgang des Vorverstärkers in beiden Schaltzuständen des als Stellglied dienenden Feldeffekttransistors praktisch der gleiche ist.

Die Maßnahmen nach Anspruch 8 haben den Vorteil, daß die Einfügung der Diode keinen Einfluß auf die Stabilität des Vorverstärkers hat.

Bei der in Anspruch 9 angegebenen Ausführungsform der Verstärkeranordnung sind in die Dynamikregelung in vorteilhafter Weise der opto-elektrische Wandler, der Vorverstärker und die regelbare Verstärkeranordnung einbezogen.

Durch die Maßnahmen nach Anspruch 10 ergibt sich der Vorteil, daß ein zur Ansteuerung eines regelbaren Verstärkers vorgesehener Differenzverstärker zugleich zur beschleunigten Ansteuerung der hysteresebehafteten Ein-Aus-Steuerschaltung ausgenutzt ist. Die dadurch bedingte schnelle Umschaltung hat den Vorteil einer Einschränkung von Bitfehlern der übertragenen Signale.

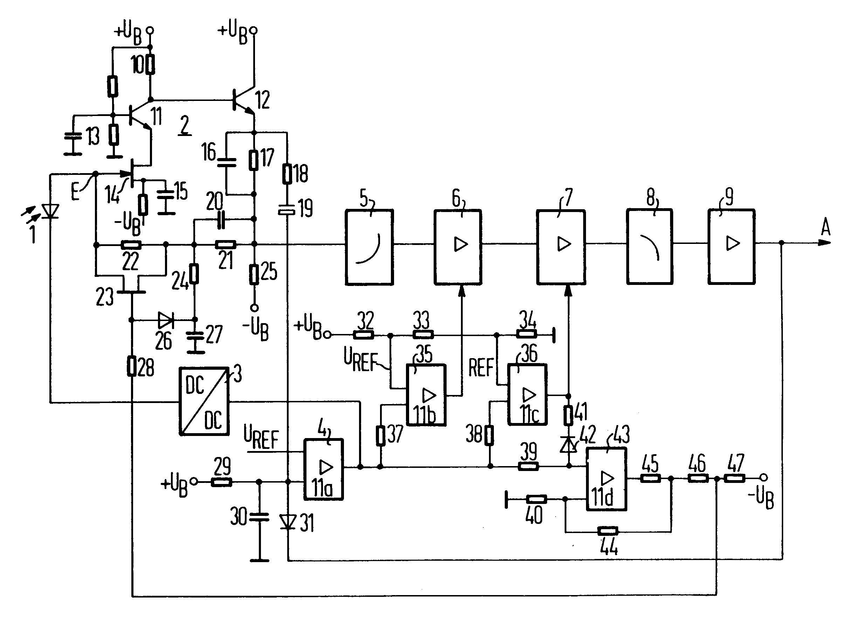

Die Erfindung wird anhand des in der Figur dargestellten Ausführungsbeispieles näher erläutert.

Die Figur zeigt eine Schaltungsanordnung mit einem an einen opto-elektrischen Wandler angeschlossenen Vorverstärker und einer dazu in Kette geschalteten regelbaren Verstärkeranordnung.

Die in der Figur gezeigte Schaltungsanordnung enthält einen Vorverstärker 2, der an die Photodiode 1, inbesondere eine Avalanche-Diode, angeschlossen ist. Der Vorverstärker 2 seinerseits enthält den ersten bipolaren Transistor 11, den zweiten bipolaren Transistor 12 und den Feldeffekttransistor 14. Bei dem ersten Transistor 11 ist die Basis über den Kondensator 13 an Bezugspotential, der Kollektor über den Widerstand 10 an die Versorgungsspannung +U_{B} und der Emitter an die Drain-Elektrode des Feldeffekttransistors 14 geführt. Bei dem Feldeffekttransistor 14 ist die Source-Elektrode über den Kondensator 15, d.h. wechselspannungsmäßig, an Masse geführt. Die Steuerelektrode des Feldeffekttransistors 14 ist mit der Anode der Photodiode 1 verbunden.

Der zweite Transistor 12 ist mit seiner Basis an den Kollektor des ersten Transistors 11 und mit seinem Kollektor an die Versorgungsspannung +U_{B} angeschlossen. Der als Emitterfolger geschaltete Transistor 12 ist mit seinem Emitter über die aus dem Widerstand 17 und dem Kondensator 16 bestehende R-C-Parallelschaltung und den dazu in Serie liegenden Widerstand 25 an die Versorgungsspannung -U_{B} geführt. Der Verbindungspunkt zwischen den Widerständen 17 und 25 bildet den Ausgang des Vorverstärkers 2, der mit dem Eingang des Hochpasses 5 verbunden und über den aus den Widerständen 21 und 22 bestehenden Gegenkopplungszweig an die Steuerelektrode des Feldeffekttransisitors 14 geführt ist.

Parallel zum Widerstand 22 liegt die Source-Drain-Strecke des als Stellglied dienenden Feldeffekttransistors 23. Dabei ist die Drain-Elektrode des Feldeffekttransistors 23 mit der Steuerelektrode des Feldeffekttransistors 14 verbunden. Zwischen der Steuerelektrode und der Source-Elektrode des Feldeffekttransistors 23 liegt die aus der Diode 26 und dem Widerstand 24 bestehende Serienschaltung. Diese Serienschaltung liegt somit parallel zur Steuerstrecke des Feldeffekttransistors 23. Die Diode 26 ist so gepolt, daß sie für Steuerspannungen, die den Feldeffekttransistor 23 leitend steuern, in Durchlaßrichtung betrieben wird. Der Verbindungspunkt von Diode 26 und Widerstand 24 ist über den Kondensator 27 an Masse geführt. Parallel zum Widerstand 21 liegt der Kondensator 20.

Auf den an den Ausgang des Vorverstärkers 2 angeschlossenen Hochpaß 5 folgt eine Kettenschaltung, die aus dem geregelten Verstärker 6, dem geregelten Verstärker 7, dem Tiefpaß 8 und dem Endverstärker 9 besteht.

Dem Steuereingang des regelbaren Verstärkers 6 ist der Differenzverstärker 35, dem Steuereingang des regelbaren Verstärkers 7 der Differenzverstärker 36 vorgeschaltet. Die Differenzverstärker 35 und 36 sind mit ihren Referenzspannungseingängen an Abgriffe des aus den Widerständen 32, 33 und 34 bestehenden Spannungsteilers angeschlossen. Bei diesem Spannungsteiler liegt der Widerstand 32 an der Versorgungsspannung +U_{B} und der Widerstand 34 an Bezugspotential. Der Referenzspannungseingang des Differenzverstärkers 35 liegt am Verbindungspunkt der Widerstand 32 und 33, der Referenzspannungseingang des Differenzverstärkers 36 am Verbindungspunkt der Widerstände 33 und 34. Die Referenzspannung des Differenzverstärkers 35 ist daher größer als die des Differenzverstärkers 36.

Der Istwerteingang des Differenzverstärkers 35 ist über den Widerstand 37, der Istwerteingang des Differenzverstärkers 36 über den Widerstand 38 an den Ausgang des Reglers 4 angeschlossen. Am Ausgang des Reglers 4 liegt außerdem der Eingang des Gleichstromwandlers 3, dessen Ausgang an die Kathode der Photodiode 1 geführt ist. Schließlich ist der Steuereingang der Ein-Aus-Steuerschaltung 43 über den Widerstand 39 an den Ausgang des Reglers 4 angeschlossen.

Außerdem ist der Ausgang des Differenzverstärkers 36 über die aus dem Widerstand 41 und der Diode 42 bestehende Serienschaltung an den Steuereingang der Ein-Aus Steuerschaltung 43 geführt. Die Diode 42 ist so gepolt, daß sie bei Ausgangsspannungen des Differenzverstärkers 36, wie sie für den Regelbereich des regelbaren Verstärkers 7 vorgesehen sind, gesperrt ist.

Die Ein-Aus-Steuerschaltung 43 ist durch einen rückgekoppelten Differenzverstärker gebildet. Bei diesem Differenzverstärker ist ein weiterer Eingang über den Widerstand 40 an Bezugspotential bzw. Masse geführt. Der Ausgang der Ein-Aus-Steuerschaltung 43 ist über die aus den Widerständen 45, 46 und 47 bestehende Serienschaltung an die Versorgungsspannung -U_{B} angeschlossen. Der Verbindungspunkt der Widerstände 45 und 46 ist über den Widerstand 44 an den weiteren Eingang des Differenzverstärkers 43, der Verbindunspunkt der Widerstände 46 und 47 über den Widerstand 28 an die Steuerelektrode des als Stellglied dienenden Feldeffekttransistors 23 geführt.

Der Regler 4 ist mit seinem Referenzspannungseingang an eine Referenzspannung U_{Ref} angeschlossen. Der Istwerteingang des Reglers 4 ist über die Diode 31 an den Ausgang der Schaltungsanordnung angeschlossen und über den Kondensator 30 an Bezugspotential und über den Widerstand 29 an die Versorgungsspannung +U_{B} geführt.

Das am Eingang E ankommende optische Signal wird in der Avalanche-Photodiode 1 in ein elektrisches Signal umgewandelt und dem rauscharmen Transimpedanz-Verstärker 2 zugeführt.

Die Versorgungsspannung für die Photodiode 1 liefert der Gleichspannungswandler 3, der durch den zur automatischen Verstärkungsregelung dienenden Regler 4 gesteuert wird.

Die verstärkungsbestimmende Gegenkopplung des Transimpedanz-Verstärkers besteht im wesentlichen aus den beiden Widerständen 21 und 22, von denen der Widerstand 22 über die Source-Drain-Strecke des Feldeffekttransistors 23 bei entsprechender Gate-Ansteuerung durch die Regelung kurzgeschlossen werden kann, wodurch die Verstärkung z. B. um ca. 40 dB abgesenkt wird.

Der nachfolgende Entzerrer-Hochpaß 5 hebt den Frequenzgang des Vorverstärkers 2 auf. Es folgen die beiden regelbaren Verstärker 6 und 7, deren frequenzunabhängiger Verstärkungsregelbereich z. B. jeweils etwa 20 dB beträgt. Die regelbaren Verstärker 6 und 7 sind insbesondere jeweils als zweistufiger breitbandiger Verstärker ausgebildet.

Bevor das Signal in der Endstufe bzw. im Endverstärker 9 nochmals verstärkt wird, erfolgt im Tiefpaß 8 eine Bandbegrenzung.

Dieser Tiefpaß ist vorzugsweise ein phasenverzerrungsfreier Gaußtiefpaß.

Die Signalamplitude am Ausgang A der Verstärkeranordnung bzw. des optischen Empfängers wird über die Verstärkungsregelung konstant gehalten.

Ausgehend von der maximalen Gesamtverstärkung bei entsprechend kleinem Eingangssignal wird bei Steigerung des Eingangspegels zunächst nur der Verstärkungsfaktor M der Photodiode 1 durch Verringerung der Vorspannung zurückgeregelt. Am Regelbereichsende der Photodiode 1, insbesondere, sobald der Verstärkungsfaktor M der Photodiode 1 etwa den Wert 1 erreicht, beginnt der erste regelbare Verstärker 6 mit der Abwärtsregelung. Dies geschieht insbesondere durch Verminderung des PIN-Diodenstromes, dem eine als Stellglied dienende PIN-Diode vom Differenzverstärker 35 gesteuert wird. Am unteren Regelbereichsende angelangt wird der zweite Verstärker 7 zurückgeregelt. An seinem Ende folgt bei weiterer Pegelsteigerung die Umschaltung des Vorverstärkers 2 durch Kurzschluß des Gegenkopplungswiderstands 22 über den Schalt-Feldeffekttransistor 23. Der hierdurch bedingte Verstärkungsabfall wird durch Hochregeln der beiden geregelten Verstärker 6 und 7 wieder ausgeglichen. Eine weitere Pegelsteigerung bis zum maximal zulässigen Eingangspegel führt zur gleichen Abwärtsregelung wie vorstehend beschrieben.

In der in der Figur gezeigten Schaltungsanordnung ist der Gegenkopplungswiderstand des als Transimpedanzverstärker ausgebildeten Vorverstärkers 2 in die beiden Widerstände 21 und 22 aufgeteilt. Einer dieser Widerstände, und zwar der Widerstand 22 kann über die Source-Drain-Strecke des Feldeffekttransistors 23 kurzgeschlossen werden. Über die Ein-Aus-Steuerschaltung 43 wird der Feldeffekttransistor hochohmig bzw. niederohmig gesteuert. Die Verstärkung des Verstärkers 2 kann damit um z. B. 40 dB abgesenkt werden.

Diese Umschaltung führt in vorteilhafter Weise zu einer wesentlichen Vergrößerung des Regelbereiches der Schaltungsanordnung, ohne daß zusätzliche Regelkreise benötigt werden. Dies ergibt sich dadurch, daß die vorhandenen Regelkreise der beiden nachfolgenden Verstärker 6 und 7 doppelt ausgenützt werden. Würde man die Erweiterung des Dynamikbereiches um z.B. 20 dB, bezogen auf den Lichtpegel, mit einer kontinuierlichen Regelung im Vorverstärker 2 realisieren, so wäre, wegen der Proportionalität Lichtleistung - Photostrom, eine Vergrößerung des Regelbereichs der Verstärkung um 40 db erforderlich. Hierfür wären z.B. zwei zusätzliche Regelkreise erforderlich.

Bei einer bevorzugten Anwendung der Schaltungsanordnung sind die von der Photodiode empfangenen optischen Signale Lichtimpulse von PCM-Signalen, die beispielsweise mit einer Übertragungsgeschwindigkeit von 34 Mbit/s übertragen werden. In diesem Fall liegt am Ausgang A ein Entscheider. Dabei soll in beiden Schaltzuständen des Feldeffekttransistors 23 etwa das gleiche Augendiagramm am Entscheider verfügbar sein. Dies bedeutet, daß die Frequenzgänge, die der Vorverstärker 2 in beiden Schaltzuständen des Feldeffekttransistors 23 hat, identisch sein sollen.

Würde man ohne den Kondensator 27 die Grenzfrequenzen des hochohmigen und niederohmigen Gegenkopplungs-Zweipols gleich dimensionieren, wobei die Grenzfrequenz des hochohmigen Gegenkopplungs-Zweipols nur durch die parasitäre Kapazität gebildet wird, so wären die Frequenzgänge beider Schaltzustände theoretisch identisch. Wegen der vergleichsweise hohen Verstärkung in der Gegenkopplungsschleife könnte es jedoch ggf. zu Eigenschwingungen kommen. Die Grenzfrequenz des niederohmigen Zweipols wird daher zweckmäßigerweise höher gewählt und zur Anpassung des Frequenzgangs bei Einschaltung des hochohmigen Zweipols der Kondensator 27 quergeschaltet. Dieser Kondensator 27 hat bei kurzgeschlossenem Gegenkopplungs-Widerstand 22 keinen Einfluß auf den Frequenzgangdes Vorverstärkers 2, da er parallel zu einem sehr niederohmigen Schaltungspunkt liegt. Der in Reihe geschaltete niederohmige Widerstand 24 bedämpft die Verstärkungsüberhöhung bei Reihenresonanz.

Die Betriebszustände des Feldeffekttransistors 23 "leitend" bzw. "nicht leitend" werden durch entsprechende Gate-Source-Spannungen eingestellt. Der relativ schmale verfügbare Gate-Source- Spannungsbereich für den Zustand "leitend" ließe sich mit einer festen Gate-Spannung nicht ohne weiteres mit der erforderlichen Sicherheit einstellen, da die Source-Spannung Schwankungen abhängig von Lichtpegel unterworfen ist. Diese Schwierigkeiten sind dadurch vermieden, daß die erforderliche Gate-Source-Spannung, die im Bereich von + 0,5 V bis - 0,8 V liegt, von der Durchflußspannung der Schottky-Diode 26 erzeugt wird. Die Diode 26 wird von der großzügig tolerierbaren Schaltspannung der Ein-Aus Steuerschaltung 43 über den Vorwiderstand 28 stromleitend gesteuert. Die Gate-Source Spannung des Feldeffekttransistors 23 wird damit unabhängig von den Schwankungen der Source-Spannung des Feldeffekttransistors bzw. der Spannung der Ein-Aus-Steuerschaltung 43 immer auf ca. 0,3 V eingestellt. Der Schaltzustand "nicht leitend" wird mit einer festen Gatespannung realisiert, die durch den aus den Widerständen 45, 46 und 47 bestehenden Spannungsteiler aus der Versorgungsspannung -U_{B} abgeleitet wird. Dies ist möglich, da der verfügbare Gate-Source- Spannungsbereich ausreichend groß ist. Die Diode 26 ist dabei gesperrt.

Besondere Anforderungen werden dann an die Schaltungsanordnung gestellt, wenn große Lichtpegel schnell eingeschaltet werden, nachdem zuvor der Vorverstärker infolge kleiner oder fehlender Lichtleistung auf große Verstärkung eingestellt war. In diesem Fall wird der Vorverstärker übersteuert, so daß die Regelung ohne besondere Maßnahmen nicht die richtige Information zum Zurückregeln der nachfolgenden Verstärker 6 und 7 und zum an schließenden Umschalten des Vorverstärkers 2 auf kleine Verstärkung bekäme. Ein Ausfall der Datensignalübertragung wäre die Folge.

Bei langsamer Änderung des Eingangspegels im Vergleich zur Regelzeitkonstante ergibt sich dieses Problem nicht, da der Vorverstärker 2 vor Einsatz der Übersteuerung durch die Ein-Aus-Steuerschaltung umgeschaltet wird.

Da je nach Übersteuerung des Vorverstärkers 2 die Emitterspannung des Transistors 12 um ca 1... 3V in Richtung der Versorgungsspannung -U_{B} verändert wird, wird dieses Kriterium als zweite Regelgröße dem Eingang des Reglers 4 zugeführt. Würde die Emitterspannung des Transistors 12 nur über den Entkopplungswiderstand 18 mit dem Eingang des Reglers 4 verbunden, so würden Exemplarstreuungen des Arbeitspunktes des Transistors 12 Auswirkungen auf die an sich konstant zu haltende Signalamplitude am Entscheider haben, wenn dies nicht mit einem besonderen Abgleich verhindert wird. Nicht ausgleichbar hingegen wären Änderungen der Signalamplitude, die durch kleine Verschiebungen des Arbeitspunkts des Transistors 12 im gesamten Lichtpegelbereich bedingt sind.

Der Kondensator 19 unterbricht jedoch die Gleichstromverbindung zwischen dem Emitter des Transistors 12 und dem Eingang des Reglers 4. Es führen somit nur sprunghafte Lichtpegelerhöhungen, die den Vorverstärker 2 übersteuern, zur Beeinflussung des Regelkreises. Die Kapazität des Kondensators 19 von z.B. 6,8 µF wird zweckmäßigerweise so gewählt, daß die Zeitkonstante der R-C-Serienschaltung 19, 29 größer ist als die Regelzeitkonstante des Regelkreises.

Der Vorverstärker 2 wird i. a. während des Betriebes nur im Ausnahmefall umgeschaltet. Trotzdem ist es wünschenswert, Bitfehler während der Umschaltzeit so gering wie möglich zu halten. Wird der Lichtpegel, bei dem der zweite geregelte Verstärker 7 gerade an seinem unteren Ende des Regelbereichs angelangt ist, langsam weitergesteigert, so sinkt die Ausgangsspannung am Operationsverstärker 36 rasch nach Minus-Potential bzw. in Richtung zur Versorgungsspannung -U_{B} ab. Die Diode 42 wird leitend und steuert die Ein-Aus-Steuerschaltung auf positive Ausgangsspannung. Über den Spannungsteiler, bestehend aus den Widerständen 46 und 47 und den Vorwiderstand 28 und die Schottky-Diode 26 wird der Feldeffekttransistor 23 in den "leitenden" Zustand gesteuert. Die Umschaltung ist auch ohne Widerstand 41 bzw. ohne die Diode 42 sichergestellt. Der Umschaltevorgang wird jedoch mit Hilfe des Widerstandes 41 und der Diode 42 durch Ausnützung der Verstärkung des Operationsverstärkers 36 in vorteilhafter Weise stark beschleunigt.

Wird der optische Empfänger bzw. die Verstärkeranordnung mit einem Lichtpegel betrieben, der im Bereich der Umschaltung des Vorverstärkers liegt, so bewirken übliche Pegelschwankungen keine Umschaltungen. Dies wird dadurch erreicht, daß die Ein-Aus-Steuerschaltung mit einer Hysterese ausgestattet ist. Mit Hilfe der Widerstände 40, 44 und 45 wird bei beiden Schaltzuständen der Ein-Aus-Steuerschaltung 43 eine entsprechend unterschiedliche Referenzspannung eingestellt. Durch geeignete Wahl der Widerstände 40 und 44 wird die Hysterese auf den Planungswert eingestellt.

## Patentansprüche

1. Schaltungsanordnung mit einem mit seinem Eingang (E) an einen opto-elektrischen Wandler (Photodiode 1) angeschlossenen Vorverstärker (2), dessen Verstärkung mit Hilfe eines durch einen Feldeffekttransistor (23) gebildeten Stellgliedes steuerbar ist,
**dadurch gekennzeichnet,**
daß eine in Kette zum Vorverstärker (2) angeordnete, wenigstens einen hinsichtlich seiner Verstärkung steuerbaren Verstärker (6, 7) enthaltende regelbare Verstärkeranordnung durch einen Regler (4) steuerbar ist, dessen Istwerteingang an einen am Ausgang (A) der Schaltungsanordnung liegenden Istwertgeber (30, 31) und über ein Differenzierglied (18, 19) an den Ausgangskreis des Vorverstärkers (2) angeschlossen ist und daß der Vorverstärker (2) in einem Gegenkopplungszweig eine Serienschaltung zweier Widerstände (21, 22) enthält und daß der das Stellglied bildende Feldeffekttransistor (23) mit seiner Drain-Source-Strecke parallel zu einem der Widerstände (22) der Serienschaltung liegt und durch eine ebenfalls an den Regler (4) angeschlossene, hysteresebehaftete Ein-Aus-Steuerschaltung (43) derart steuerbar ist, daß bei einem ersten Schaltzustand der Steuerschaltung (43) der Feldeffekttransistor (23) gesperrt und im zweiten Schaltzustand der Steuerschaltung (43) leitend ist und daß die Ein-Aus-Steuerschaltung (43) durch den Regler (4) derart steuerbar ist, daß sie vom ersten in den zweiten Schaltzustand übergeht, wenn die regelbare Verstärkeranordnung (Verstärker 6, 7) bei steigendem Eingangspegel der Schaltungsanordnung wenigstens näherungsweise den Zustand minimaler Verstärkung erreicht.

2. Schaltungsanordnung nach Anspruch 1,
**dadurch gekennzeichnet,**
daß der Vorverstärker (2) einen ersten Transistor (11), dessen Kollektor über einen Widerstand (10) an eine erste Versorgungsspannung (+U_{B}) geführt ist und einen zweiten Transistor (12) in Kollektor-Grundschaltung enthält, und daß die Basis des zweiten Transistors (12) mit dem Kollektor des ersten Transistors (11) verbunden ist und daß der Gegenkopplungszweig (21, 22) an den Emitterstromkreis des zweiten Transistors (12) angeschlossen ist.

3. Schaltungsanordnung nach Anspruch 2,
**dadurch gekennzeichnet,**
daß zwischen dem Emitter des ersten Transistors (11) und Bezugspotential (Masse) die gesteuerte Strecke eines weiteren Transistors (14) liegt und daß der Gegenkopplungszweig (21, 22) und der opto-elektrische Wandler (Photodiode 1) mit der Steuerelektrode dieses Transistors (14) verbunden sind.

4. Schaltungsanordnung nach einem der Ansprüche 1 bis 3,
**dadurch gekennzeichnet,**
daß der Istwerteingang des Reglers (4) über eine RC-Serienschaltung (18, 19) an den Emitter des zweiten Transistors (12) angeschlossen ist, und daß der Ausgang des Vorverstärkers (2) durch den Verbindungspunkt zweier Widerstände (17, 25) gebildet ist, deren Serienschaltung den Emitterstromkreis bildet und daß parallel zu dem Widerstand (17) der Serienschaltung, der zwischen dem Emitter des zweiten Transistors (12) und dem Ausgang des Vorverstärkers (2) liegt, ein Kondensator (16) angeordnet ist.

5. Schaltungsanordnung nach einem der Ansprüche 1 bis 4,
**dadurch gekennzeichnet,**
daß zwischen dem Vorverstärker (2) und der regelbaren Verstärkeranordnung (6, 7) ein Hochpaß (5) und zwischen der regelbaren Verstärkeranordnung (6, 7) und dem Ausgang (A) der Schaltungsanordnung ein Tiefpaß (8) angeordnet sind.

6. Schaltungsanordnung nach einem der Ansprüche 1 bis 5,
**dadurch gekennzeichnet,**
daß parallel zur Steuerstrecke des das Stellglied bildenden Feldeffekttransistors (23) eine für diesen Feldeffekttransistor (23) leitend steuernde Steuerspannungen in Durchlaßrichtung gepolte Diode (26) liegt.

7. Schaltungsanordnung nach einem der Ansprüche 1 bis 6,
**dadurch gekennzeichnet,**
daß der Verbindungspunkt der Widerstände (21, 22) des Gegenkopplungszweiges über eine R-C-Serienschaltung (24, 27) an Bezugspotential (Masse) geführt ist, und daß parallel zu dem Widerstand (21) des Gegenkopplungszweiges, der bei leitendem Stellglied-Feldeffekttransistor (23) wirksam bleibt, ein Kondensator (20) angeordnet ist.

8. Schaltungsanordnung nach Anspruch 6 und 7,
**dadurch gekennzeichnet,**
daß die Diode (26) zwischen der Steuerelektrode des Stellglied-Feldeffekttransistors (23) und dem Verbindungspunkt zwischen dem Widerstand (24) und dem Kondensator (27) der RC-Serienschaltung angeordnet ist.

9. Schaltungsanordnung nach einem der Ansprüche 1 bis 8,
**dadurch gekennzeichnet,**
daß der opto-elektrische Wandler (Photodiode 1) mit einem an den Ausgang des Reglers (4) angeschlossenen Gleichsspannungswandler (3) verbunden ist.

10. Schaltungsanordnung nach einem der vorhergehenden Ansprüche,
**dadurch gekennzeichnet,**
daß ein steuerbarer Verstärker (7) mittels eines an den Regler (4) angeschlossenen Differenzverstärkers (36) steuerbar ist, und daß der Steuereingang der Ein-Aus-Steuerschaltung (43) sowohl über einen Widerstand (39) an den Ausgang des Reglers (4) als auch über einen eine Diode (42) und einen dazu in Serie liegenden Widerstand (41) enthaltenden Stromzweig an den Ausgang des Differenzverstärkers (36) angeschlossen ist und daß die Diode (42) derart gepolt ist, daß sie bei im Regelbereich des steuerbaren Verstärkers (7) liegenden Ausgangsspannungen des Differenzverstärkers (36) gesperrt ist.

## Claims

1. Circuit arrangement having a preamplifier (2) which is connected by means of its input (E) to an opto-electrical transducer (photodiode 1) and whose gain is controllable with the aid of a final control element which is formed by a field-effect transistor (23), characterised in that a controllable amplifier arrangement, which is arranged in cascade with the preamplifier (2) and contains at least one amplifier (6, 7) whose gain can be controlled, can be controlled by a regulator (4) whose actual value input is connected to an actual value transmitter (30, 31), which is connected to the output (A) of the circuit arrangement, and, via a differentiating element (18, 19) to the output circuit of the preamplifier (2), and in that the preamplifier (2) contains a series circuit of two resistors (21, 22) in a negative-feedback branch, and in that the field-effect transistor (23) forming the final control element is connected with its drain-source junction in parallel with one of the resistors (22) of the series circuit and is controllable by means of an on-off control circuit (43) which is likewise connected to the regulator (4) and has hysteresis, in such a manner that the field-effect transistor (23) is switched off in a first switching state of the control circuit (43) and is switched on in the second switching state of the control circuit (43), and in that the on-off control circuit (43) can be controlled by the regulator (4) in such a manner that it changes from the first to the second switching state when the controllable amplifier arrangement (amplifiers 6, 7) reaches at least approximately the state of minimum gain when the input level of the circuit arrangement is rising.

2. Circuit arrangement according to Claim 1, characterised in that the preamplifier (2) contains a first transistor (11) whose collector is connected via a resistor (10) to a first supply voltage (+U_{B}) and contains a second transistor (12) in the basic collector circuit, and in that the base of the second transistor (12) is connected to the collector of the first transistor (11), and in that the negative-feedback branch (21, 22) is connected to the emitter circuit of the second transistor (12).

3. Circuit arrangement according to Claim 2, characterised in that the controlled junction of a further transistor (14) is connected between the emitter of the first transistor (11) and the reference potential (earth), and in that the negative-feedback branch (21, 22) and the opto-electrical transducer (photodiode 1) are connected to the control electrode of this transistor (14).

4. Circuit arrangement according to one of Claims 1 to 3, characterised in that the actual value input of the regulator (4) is connected via an RC-series circuit (18, 19) to the emitter of the second transistor (12), and in that the output of the preamplifier (2) is formed by the connecting point of two resistors (17, 25), whose series circuit forms the emitter circuit, and in that a capacitor (16) is arranged in parallel with the resistor (17) of the series circuit which is located between the emitter of the second transistor (12) and the output of the preamplifier (2).

5. Circuit arrangement according to one of Claims 1 to 4, characterised in that a high-pass filter (5) is arranged between the preamplifier (2) and the controllable amplifier arrangement (6, 7), and a low-pass filter (8) is arranged between the controllable amplifier arrangement (6, 7) and the output (A) of the circuit arrangement.

6. Circuit arrangement according to one of Claims 1 to 5, characterised in that, connected in parallel with the control junction of the field-effect transistor (23) forming the final control element is a diode (26) which is polarised in the forward direction for control voltages which control the switching-on of this field-effect transistor (23).

7. Circuit arrangement according to one of Claims 1 to 6, characterised in that the connecting point of the resistors (21, 22) of the negative-feedback branch is connected via an RC-series circuit (24, 27) to the reference potential (earth), and in that a capacitor (20) is arranged in parallel with the resistor (21) of the negative-feedback branch which remains effective when the final control element field-effect transistor (23) is switched on.

8. Circuit arrangement according to Claims 6 and 7, characterised in that the diode (26) is arranged between the control electrode of the final control element field-effect transistor (23) and the connecting point between the resistor (24) and the capacitor (27) of the RC-series circuit.

9. Circuit arrangement according to one of Claims 1 to 8, characterised in that the opto-electrical transducer (photodiode 1) is connected to a DC voltage transducer (3) which is connected to the output of the regulator (4).

10. Circuit arrangement according to one of the preceding claims, characterised in that a controllable amplifier (7) can be controlled by means of a differential amplifier (36) which is connected to the regulator (4), and in that the control input of the on-off control circuit (43) is connected both via a resistor (39) to the output of the regulator (4) and via a current branch containing a diode (42) and a resistor (41) which is located in series therewith to the output of the differential amplifier (36), and in that the diode (42) is polarised in such a manner that it is blocked at output voltages of the differential amplifier (36) which lie in the control range of the controllable amplifier (7).

## Revendications

**1.** Montage comportant un préamplificateur (2) qui est raccordé par son entrée (E) à un transducteur optoélectrique (photodiode 1) et dont l'amplification peut être commandée à l'aide d'un circuit de réglage formé par un transistor à effet de champ (23),
caractérisé par le fait
qu'un dispositif amplificateur réglable, qui est branché en série avec le préamplificateur (2) et qui comporte au moins un amplificateur (6,7) dont l'amplification, peut être commandé par un régulateur (4) dont l'entrée de la valeur réelle est raccordée à un générateur de valeurs réelles (30,31), qui est raccordé à la sortie (A) du montage, et au circuit de sortie du préamplificateur (2) par l'intermédiaire d'un circuit différentiateur (18,19), et que le préamplificateur (2) comporte, dans une branche de contre-réaction, un montage série formé de deux résistances (21,22), et que le transistor à effet de champ (23), qui constitue le circuit de réglage, est branché en parallèle, par sa voie drain-source, avec l'une des résistances (22) du montage série et peut être commandé par un circuit de commande de marche-arrêt (43), qui est également raccordé au régulateur (4) et présente une hystérése, de telle sorte que, pour un premier état de commutation du circuit de commande (43), le transistor à effet de champ (23) est bloqué, alors qu'il est conducteur pour le second état de commutation du circuit de commande (43), et que le circuit de commande (marche-arrêt (43) peut être commandé par le régulateur (4) de manière à être commuté du premier dans le second état de commutation, lorsque le dispositif d'amplification réglable (amplificateurs 6, 7) atteint au moins approximativement l'état d'amplification minimale, lorsque le niveau d'entrée du montage augmente.

**2.** Montage suivant la revendication 1, caractérisé par le fait
que le préamplificateur (2) comporte un premier transistor (11), dont le collecteur est raccordé, par l'intermédiaire d'une résistance (6), à une première tension d'alimentation (+U_{B}), et un second transistor (12) branché selon un montage en collecteur commun, et que la base du second transistor (12) est raccordée au collecteur du premier transistor (11) et que la branche de contre-réaction (21,22) est raccordée au circuit d'émetteur du second transistor (12).

**3.** Montage suivant la revendication 2, caractérisé par le fait
que la section commandée d'un autre transistor (14) est branchée entre l'émetteur du premier transistor (11) et le potentiel de référence (MOS) et que la branche de contre-réaction (21,22) et le transducteur optoélectrique (photodiode 1) sont raccordés à l'électrode de commande de ce transistor (14).

**4.** Montage suivant l'une des revendications 1 à 3, caractérisé par le fait
que l'entrée des valeurs réelles du régulateur (4) est raccordée, par l'intermédiaire d'un circuit série RC (18,19), à l'émetteur du second transistor (12) et que la sortie du préamplificateur (2) est formée par le point de jonction de deux résistances (17,25), dont le branchement série forme le circuit d'émetteur, et qu'un condensateur (16) est branché en parallèle avec la résistance (17) du circuit série, qui est disposé entre l'émetteur du second transistor (12) et la sortie du préamplificateur (2).

**4.** Montage suivant l'une des revendications 1 à 4, caractérisé par le fait
qu'un filtre passe-haut (5) est branché entre le préamplificateur (2) et le dispositif d'amplification réglable (6,7) et qu'un filtre passe-bas (8) est branché entre le dispositif d'amplification réglable (6,7) et la sortie (A) du montage.

**6.** Montage suivant l'une des revendications 1 à 5, caractérisé par le fait
qu'en parallèle avec la section de commande du transistor à effet de champ (23) constituant le circuit de réglage, est branchée une diode polarisée dans le sens passant pour des tensions de commande qui placent à l'état conducteur ce transistor à effet de champ (23).

**7.** Montage suivant l'une des revendications 1 à 6, caractérisé par le fait
que le point de jonction des résistances (21,22) de la branche de contre-réaction est raccordé, par l'intermédiaire d'un circuit série R-C (24,27), au potentiel de référence (MOS), et qu'un condensateur (20) est branché en parallèle avec la résistance (21) de la branche de contre-réaction qui reste active lorsque le transistor à effet de champ (23) constituant le circuit de réglage est conducteur.

**8.** Montage suivant les revendications 6 et 7, caractérisé par le fait
que la diode (26) est disposée entre l'électrode de commande du transistor à effet de champ (23) constituant le circuit de réglage et le point de jonction entre la résistance (24) et le condensateur (27) du circuit série RC.

**9.** Montage suivant l'une des revendications 1 à 8, caractérisé par le fait
que le transducteur optoélectrique (photodiode 1) est raccordé à un transformateur de tension continue (3), qui est raccordé à la sortie du régulateur (4).

**10.** Montage suivant l'une des revendications précédentes, caractérisé par le fait
qu'un amplificateur commandable (7) peut être commandé au moyen d'un amplificateur différentiel (36) raccordé au régulateur (4), que l'entrée de commande du circuit de commande de marche-arrêt (43) est raccordée aussi bien par l'intermédiaire d'une résistance (39) à la sortie du régulateur (4) que par l'intermédiaire d'une branche de circulation de courant, qui comporte une diode (42) et une résistance (41) branchée en série avec cette dernière, à la sortie de l'amplificateur différentiel (36), et que la diode (42) est polarisée de telle sorte qu'elle est bloquée pour des tensions de sortie de l'amplificateur différentiel (36), qui sont situées dans la plage de réglage de l'amplificateur commandable (7).
